Europäisches Patentamt

(19) European Patent Office

Office européen des brevets

(11) Numéro de publication : **0 444 370 A1**

# (12) DEMANDE DE BREVET EUROPEEN

(21) Numéro de dépôt : 90403783.5

(22) Date de dépôt : 27.12.90

(51) Int. Cl.[5] : **H01L 21/76, G01L 9/00, H01L 31/0352**

Le titre de l'invention a été modifié (Directives relatives à l'examen pratiqué à l'OEB, A-III, 7.3)

(30) Priorité : 29.12.89 FR 8917444

(43) Date de publication de la demande : 04.09.91 Bulletin 91/36

(84) Etats contractants désignés : DE GB IT

(71) Demandeur : **TELEMECANIQUE 43-45, Boulevard Franklin Roosevelt F-92500 Rueil Malmaison (FR)**

(72) Inventeur : **Cros, Christophe 12 rue Sadi Carnot F-92000 Nanterre (FR)** Inventeur : **Hampikian, Pascal 71 rue Louis Blanc F-75010 Paris (FR)**

(74) Mandataire : **Martin, Jean-Jacques et al Cabinet REGIMBEAU 26, Avenue Kléber F-75116 Paris (FR)**

(54) **Dispositif semi-conducteur à régime activé aminci et son procédé de fabrication.**

(57)    L'invention concerne un procédé de fabrication d'un dispositif semiconducteur à région active amincie.

Le procédé consiste à former dans une tranche épaisse (10) de matériau semiconducteur une couche isolante interne (13) située à une distance de la face avant (21) qui équivaut à l'épaisseur souhaitée de la région active, à graver sélectivement le matériau par voie chimique à partir de la face arrière (22) pour creuser des cuvettes (24), et à enlever la partie de la couche isolante qui est située au fond des cuvettes.

Application aux composants de puissance et aux capteurs.

EP 0 444 370 A1

# PROCEDE POUR FABRIQUER UN DISPOSITIF SEMICONDUCTEUR, DISPOSITIF ET COMPOSANT SEMICONDUCTEUR OBTENUS PAR LE PROCEDE

La présente invention concerne un procédé de fabrication d'un dispositif semiconducteur à couche interne isolante, ce procédé se prêtant particulièrement à la réalisation de composants de puissance à région active relativement mince.

Il est connu de réaliser des tranches épaisses en silicium munies d'une couche isolante interne par mise directe en adhérence de deux tranches primaires, dont les faces polies à mettre en contact auront préalablement été oxydées.

Il est d'autre part souhaitable d'obtenir des composants semiconducteurs de puissance à région active mince afin de bien contrôler l'injection des porteurs, comme décrit dans le brevet EP-148 065 sans risquer la rupture des tranches au cours du processus.

L'invention a pour but de permettre de fabriquer à partir de substrats monocristallins épais des dispositifs semiconducteurs se prêtant bien aux applications précitées et ce par un procédé simple à mettre en oeuvre.

Elle a pour autre but de faciliter le dopage de ces dispositifs et/ou leurs prises de contact.

Le procédé selon l'invention est caractérisé par les étapes suivantes:

– formation d'une couche isolante interne dans une tranche épaisse en matériau semiconducteur monocristallin, la couche isolante étant parallèle aux faces principales avant et arrière de la tranche, en étant située à une distance de la face avant qui équivaut à l'épaisseur souhaitée de la région active,

– gravure sélective par voie chimique sèche ou humide du matériau semicondcuteur à partir de la face arrière pour creuser dans la tranche une pluralité de cuvettes dont le fond atteint la couche isolante tout en laissant subsister autour de chaque cuvette une couronne épaisse de rigidité,

– ablation de la partie de la couche isolante qui est située au fond de la cuvette, et

– métallisation complète de la cuvette et de la couronne du côté de la face arrière.

Le dispositif semiconducteur est ensuite élaboré par des étapes de dopage, métallisation et passivation. Il peut être avantageux de réaliser la formation d'une couche N ou P au fond de la cuvette par un dopage autocentré exécutable sans inconvénient sur la totalité de la face arrière du dispositif, cette formation étant suivie d'une métallisation partielle de la face avant et d'une métallisation complète de la cuvette et de la couronne sur la face arrière. L'épaisseur de la région centrale active sera avantageusement comprise entre environ 80 μm et 200 μm.

L'invention concerne également les dispositifs tels que circuits ou composants obtenus par le procédé décrit.

D'autres caractéristiques et avantages de l'invention apparaîtront à la lecture de la description détaillée ci-après d'un exemple d'application à un composant semiconducteur de puissance, en regard des figures annexées.

– La figure 1 représente en couche schématique une portion de tranche semiconductrice réalisée par le procédé selon l'invention.

– Les figures 2 à 8 montrent en coupe les étapes successives de réalisation d'un composant de puissance conformément à l'invention.

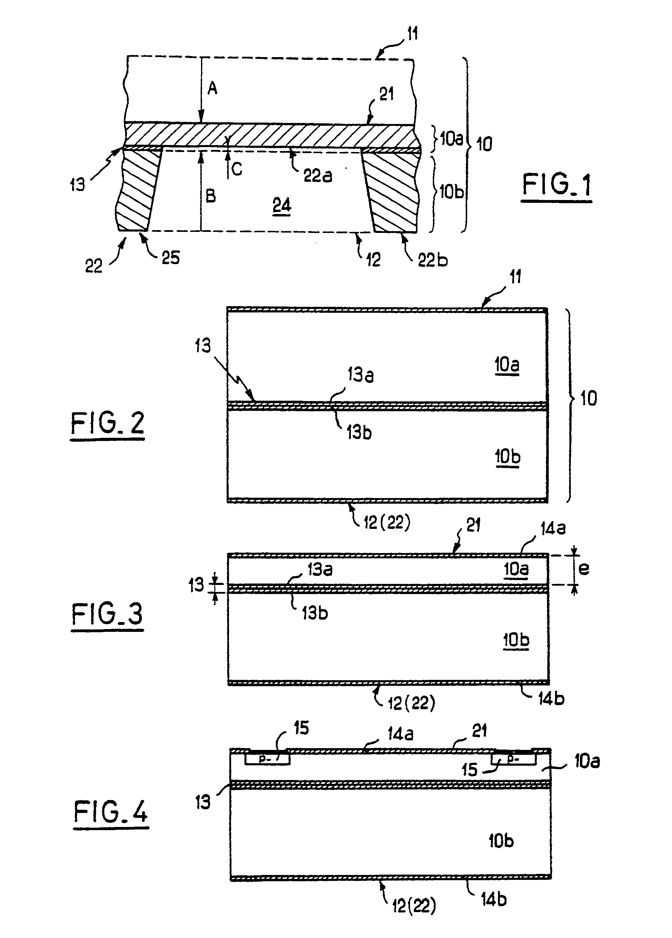

Le circuit ou composant semiconducteur illustré sur la figure 1 est élaboré à partir d'une tranche 10 en matériau semiconducteur monocristallin. La tranche présente une première face 11, une deuxième face 12 et une couche isolante interne 13 parallèle aux faces 11, 12; cette couche interne est réalisée de manière en soi connue.

Le circuit ou composant 20 comprend une face avant 21 et une face arrière 22. La face avant 21 est engendrée par réduction d'épaisseur A à partir de la face 11 d'origine de la tranche. La face arrière 22 présente une partie périphérique 22b au niveau de la face 12 et une partie centrale 22a obtenue par réduction d'épaisseur à partir de la face 12, cette partie centrale constituant ainsi une cuvette 24 bordée par une couronne 25, puis par enlèvement de la partie de la couche isolante interne 13 d'épaisseur C qui est située au fond de la cuvette.

Le circuit ou composant peut alors subir les opérations usuelles de dopage, de formation de couches isolantes et conductrices et de prise de contact, de passivation... Il convient d'observer que le circuit ou composant comprend une partie "active" 10a d'épaisseur réduite, solidaire d'une partie "passive" 10b qui est épaisse relativement à la partie 10a et qui assure la bonne tenue mécanique de l'ensemble.

Pour montrer l'intérêt de cette technologie, les étapes de fabrication d'un composant de puissance pris comme exemple d'application vont être décrites en regard des figures 2 à 8.

La tranche 10 résulte de la mise en adhérence de deux tranches primaires 10a, 10b de silicium. Les tranches monocristallines 10a, 10b sont par exemple épaisses chacune de 500 μm et leurs faces à mettre en contact sont préalablement polies par voie mécano-chimique et oxydées. La couche isolante interne 13 est ainsi formée par la réunion des couches d'oxyde 13a, 13b, par exemple d'épaisseur voisine de 1 μm, formées respectivement sur les tranches 10a, 10b. La tranche passive 10b a un type de conductivité identique ou opposé à celui de la tranche 10a. Les orientations cristallographiques des deux tranches peuvent être différentes; celle de la tranche passive 10b est liée au mode de gravure employé pour réaliser la cuvette 24. Les épaisseurs des tranches de départ 10a, 10b peuvent bien entendu être différentes et le matériau semiconducteur peut être autre que le silicium.

La réduction d'épaisseur A (figure 3) est effectuée chimiquement et/ou mécaniquement jusqu'à l'obention de l'épaisseur e souhaitée, de préférence de l'ordre de 80 µm à 200 µm, pour la région centrale active du composant. La tranche 10 est alors soumise à une oxydation sous atmosphère humide. L'épaisseur des couches d'oxyde 14a, 14b résultantes dépend du composant à réaliser.

La face avant 21 de la tranche active 10a va à présent faire l'objet d'opérations usuelles pour la fabrication d'un composant de puissance: élaboration d'éléments de tenue en tension, traitements thermiques...., la tranche passive 10b servant essentiellement de support mécanique.

La figure 4 montre ainsi des poches latérales 15 faiblement dopées P, ces poches étant implantées et diffusées avec une profondeur et une largeur dépendant de la tenue en tension souhaitée.

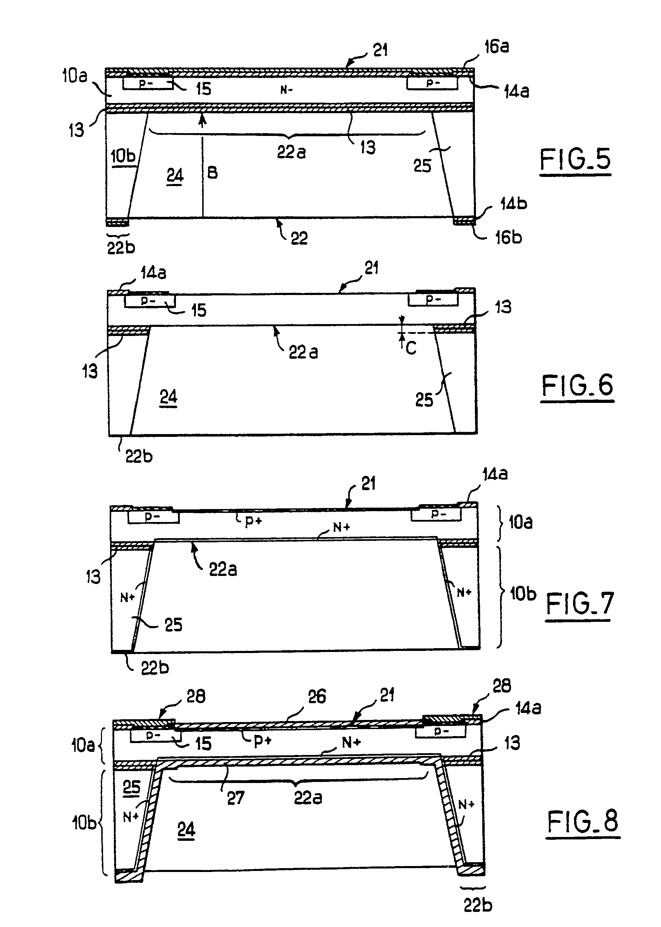

On dépose ensuite (figure 5) une couche de protection 16a sur la face avant 21 et une couche de protection 16b sur la face arrière 22 du composant. Les couches de protection 16a, 16b sont en nitrure de silicium, en résine, cire ou analogue. Leur épaisseur est déterminée pour résister à l'attaque qui va suivre. Sur la face arrière 22, la couche de protection 16b et la couche d'oxyde 14b sont ouvertes par photogravure pour définir une région centrale dans laquelle le silicium est mis à nu tout en laissant subsister une couronne protégée 22b. Le silicium de la région centrale est ensuite gravé par des moyens classiques d'attaque anisotropique ou isotropique, humide ou sèche, jusqu'au niveau de la couche isolante 13 d'interface entre les tranches active 10a et passive 10b. La couche isolante 13 en silice sert de couche tampon pour arrêter la gravure; l'épaisseur de la couche 13 est déterminée pour assurer la maîtrise de la cinétique de gravure.

Par ce mode opératoire, on creuse la cuvette centrale 24 tout en conservant pour la rigidité mécanique la couronne de support 25. La pente des flancs de la cuvette est déterminée par le type d'attaque choisi.

Ensuite (voir figure 6), les couches de protection 16a, 16b et la couche d'oxyde 14b sont éliminées sur les faces avant et arrière du composant. La couche d'oxyde 14a de la face avant est ouverte de manière à former une fenêtre dégageant partiellement les poches de tenue en tension 15. La partie de la couche isolante 13 qui forme jusque là le fond de la cuvette centrale 24 est enlevée, éventuellement par la même opération que pour la couche 14b ou 16b si elle est de même nature.

On notera que le fond 22a de la cuvette 24 a le poli optique originel de la tranche active 10a et que ce fond 22a est automatiquement délimité par les bords de la cuvette sans que soit nécessaire une opération de centrage.

Des dopages, dont les types et les profils sont fonction du composant à réaliser, sont alors entrepris du côté de la face avant 21 et de la face arrière 22a de la tranche active 10a (figure 7). Les régions dopées par prédépôt ou de préférence par implantation sont référencées N+ et P+ sur les figures. Elles sont avantageusement minces lorsqu'on veut réaliser un composant de puissance à contrôle d'injection, selon l'enseignement du brevet EP 148 065. Des anneaux de garde peuvent être prévus.

Il convient de noter que l'implantation par exemple de type N+ réalisée vers la face arrière 22 du composant peut s'effectuer sans masquage. En effet, la couronne 25 résiduelle de la tranche passive 10b peut sans inconvénient être dopée N+ puisqu'elle est totalement isolée de la tranche active 10a par la couche isolante résiduelle 13.

On effectue ensuite un traitement thermique d'activation et de diffusion de la charge implantée. Puis le dépôt de métallisations 26,27 est effectué sur les faces avant 21 et arrière 22 du composant pour permettre la prise de contacts. Il n'est pas besoin d'effectuer de photogravure en face arrière, grâce à la présence de la couche isolante résiduelle 13, et les prises de contact peuvent avantageusement être localisées sur les couronnes plutôt qu'au fond des cuvettes. Une couche de passivation 28 est déposée sur la partie supérieure de la tranche active 10a, puis cette couche est ouverte afin de permettre la prise de connexion.

Le procédé qui vient d'être décrit s'applique à la fabrication de circuits ou de composants semiconducteurs de puissance tels que diodes, transistors, thyristors, IGBT, de type bipolaire ou MOS, dont le côté cathode est situé vers la face avant, voire vers la face arrière. Il est particulièrement bien adapté aux composants de puissance à contrôle d'injection.

## Revendications

1. Procédé de fabrication d'un dispositif semiconducteur comprenant une face avant, une face arrière et une région active amincie, ce procédé étant caractérisé par les étapes suivantes:
   – formation d'une couche isolante interne (13) dans une tranche épaisse (10) en matériau semiconducteur monocristallin, la couche isolante étant parallèle aux faces principales avant (21) et arrière (22) de la tranche, en étant située à une distance de la face avant qui équivaut à l'épaisseur (e) souhaitée de la région active,

– gravure sélective par voie chimique du matériau semiconducteur à partir de la face arrière pour creuser dans la tranche une pluralité de cuvettes (24) dont le fond atteint la couche isoalnte (13) tout en laissant subsister autour de chaque cuvette une couronne épaisse (25) de rigidité,
– ablation de la partie de la couche isolante (13) qui est située au fond de chaque cuvette, et
– métallisation complète de la cuvette (24) et de la couronne (25) du côté de la face arrière (22).

2. Procédé selon la revendication 1, caractérisé par le fait que la couche isolante interne (13) est formée par:
– mise en autoadhérence directe d'une tranche primaire active (10a) et d'une tranche primaire passive (10b) en matériau semiconducteur dont les faces à mettre en contact ont été préalablement polies, puis munies d'une couche isolante, et
– ablation d'une partie de l'épaisseur de la tranche active (10a) pour obtenir la face avant (21) souhaitée.

3. Procédé selon la revendication 1 ou 2, caractérisé par le fait que la gravure sélective par voie chimique en face arrière s'effectue par:
– dépôt sur la face avant (21) et sur la partir de la face arrière (22) correspondant à la couronne épaisse (25), d'une couche de protection (16a,16b), et
– gravure de la face arrière par un agent de gravure sélective qui attaque le matériau semiconducteur, mais n'attaque pas la couche de protection (16b).

4. Procédé selon l'une des revendications 1 à 3, caractérisé par la formation, avant métallisation, d'une couche N ou P au fond de la cuvette (24) par un dopage autocentré.

5. Procédé selon l'une des revendications 1 à 4, caractérisé par la formation sur la face avant (21) d'éléments (15) de protection périphérique de type de conductivité opposé à celui du matériau semiconducteur de la tranche active (10a).

6. Dispositif semiconducteur réalisé par le procédé selon l'une des revendications 1 à 5.

7. Composant semiconducteur de puissance obtenu par le procédé selon l'une des revendications 1 à 5, caractérisé par une région centrale active amincie et une région périphérique épaisse, cette dernière comprenant une couronne épaisse (25) dotée d'une couche interne isolante (13) et électriquement isolée de la région centrale active.

FIG.1

FIG.2

FIG.3

FIG.4

FIG.5

FIG.6

FIG.7

FIG.8

**Office européen des brevets**

# RAPPORT DE RECHERCHE EUROPEENNE

Numero de la demande

EP 90 40 3783

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 150 827 (HITACHI) <br> * Figure 5; revendications * <br> --- | 1,3,6 | H 01 L 21/76 <br> G 01 L 9/00 <br> H 01 L 31/0352 |
| Y | WO-A-8 906 045 (WISCONSIN ALUMNI RESEARCH FOUNDATION) <br> * Figures 5-10; page 22, ligne 12 - page 23, ligne 32 * <br> --- | 1,3,6 | |
| A | US-A-4 814 856 (KULITE SEMICONDUCTOR PRODUCTS) <br> * Abrégé * <br> --- | 2 | |
| A | EP-A-0 323 856 (TOSHIBA) <br> * Figures 3A-3G; colonne 4, ligne 37 - colonne 5, ligne 7 * <br> --- | 1 | |
| D,A | EP-A-0 148 065 (FAIRCHILD) <br> * Abrégé * <br> ----- | 1 | |

DOMAINES TECHNIQUES RECHERCHES (Int. Cl.5)

H 01 L
G 01 L

Le présent rapport a été établi pour toutes les revendications

| Lieu de la recherche | Date d'achèvement de la recherche | Examinateur |
|---|---|---|
| LA HAYE | 08-04-1991 | GORI P. |